# EUROPEAN PATENT APPLICATION

(11) **EP 4 819 822 A1**
(43) Date of publication of application: **07.10.2026**
(21) Application number: 26162737.6
(22) Date of filing: 05.03.2026
(51) Int. Cl.: H10N 60/20, H03F 19/00, H10N 60/01, H10N 60/81, G06N 10/40

(54) **PACKAGING OF KINETIC INDUCTANCE TRAVELLING-WAVE PARAMETRIC AMPLIFIER (KTWPA) DEVICE**

(30) Priority: 31.03.2025 US 202519096141
(71) Applicant: Microsoft Technology Licensing, LLC, Redmond, WA 98052-6399 (US)
(72) Inventor: Nystrom, Michael James, Redmond, 98052-6399 (US); Chapman, Benjamin James, Redmond, 98052-6399 (US); Lucas, Marijn Thomas, Redmond, 98052-6399 (US)
(74) Representative: Page White Farrer

(57) **Abstract**

A kinetic inductance travelling-wave parametric amplifier (KTWPA) device is provided that includes a metallic enclosure (302) having a base including an inside top surface, sides, and an enclosure lid (308), a substrate (402) coupled to the inside top surface of the base, the substrate including a plurality of conductive pads (206), a silicon die (202) including a superconducting transmission line (200), the silicon die coupled to the substrate, a plurality of conductive spacers (210) coupled to the silicon die, wire bonds (208) attached between the conductive pads and the silicon die, and a copper lid (212) coupled to the top end of the plurality of conductive spacers, where the copper lid is electrically and thermally coupled to the enclosure lid. The KTWPA device may be applied in a quantum microwave measurement circuit to amplify a quantum measurement signal from a quantum circuit.

## Description

### BACKGROUND

Quantum computers typically make use of quantum-mechanical phenomena, such as superposition and entanglement, to perform operations on data more efficiently than a classical digital computer which stores and manipulates information in the form of bits (e.g., a "1" or "0"). By contrast, quantum computing systems can manipulate information using qubits. Superposition is a fundamental concept in quantum mechanics, describing the condition in which a quantum system can exist in multiple states or configurations simultaneously. A qubit can refer to a quantum device that enables the superposition of multiple states (e.g., data in both the "0" and "1" state) and/or to the superposition of data, itself, in the multiple states. In accordance with conventional terminology, the superposition of a "0" and "1" state in a quantum system may be represented, e.g., as α|0 ^{>} +β|1^{>}. The "0" and "1" states of a digital computer are analogous to the |0^{>} and |1^{>} basis states, respectively of a qubit. The value |α|² represents the probability that a qubit is in |0^{>} state, whereas the value |β|² represents the probability that a qubit is in the |1^{>} basis state. Because a qubit can be in a superposition of 0 and 1, the quantum computer can perform multiple computations in parallel by processing all possible states of the qubits at once.

Quantum computing research has made significant progress in both quantum algorithms and quantum hardware toward improving the computational power and reliability of quantum computing. Quantum computers based on topological qubits are a promising path to scaled, low-error quantum computing. Unlike current qubit implementations, which are often based on elementary particles such as ions, electrons or photons, topological qubits are based on a topological state, or phase, of matter. Topological qubits are theorized to be more stable than any other qubit engineered to date because quantum information is stored in the topological properties of a physical system rather than in the properties of individual particles or atoms. An example implementation for topological qubits includes storing quantum information in the two ends of a superconducting nanowire. Topological qubits are less sensitive to noise at either end individually.

One-dimensional topological superconductors (1DTSs) are a promising platform for building topological qubits. The basic structure of a topological qubit places a suitable semiconductor nanowire in close proximity to a superconductor. Due to the proximity, the semiconductor nanowire also becomes superconducting and under the right conditions, including an appropriate magnetic field along the wire and voltages applied to the device, the semiconductor nanowire enters the topological phase. Quantum information is stored in the fermion parity of Majorana zero modes (MZMs) localized at the ends of superconducting wires, and projective measurements of the fermion parity are used to process quantum information and perform qubit state readout. The fermion parity shared by a pair of MZMs can be determined through reflectometry measurement.

The interferometric measurement is performed in part by using a microwave readout chain that is designed to minimize the system noise temperature. A near-quantum limited amplifier such as a kinetic inductance travelling-wave parametric amplifier (KTWPA) device is often chosen as the first amplifier in the readout chain that is coupled to the 1DTS device to obtain reflectometry measurements at the desired very low noise level, along with various low-pass and infrared filters and shielding to suppress stray radiation from impinging on the 1DTS device. The KTWPA device thus provides the ability to amplify weak microwave signals from the reflectance measurement of the quantum device at a very low noise floor.

Another requirement for the KTWPA device includes the ability to handle relatively strong pump signals that are provided as part of the amplification process. Energy dissipation from the pump signal within the KTWPA device, if not adequately designed for, can lead to a thermal runaway condition in which the temperature of a portion of the KTWPA device rises above a critical temperature to maintain superconductivity, leading to a failure condition.

It would be desirable to provide a KTWPA device that is designed and packaged to provide improved amplification of weak microwave signals at a very low noise floor while maintaining reliable operation across a higher amplitude of charge pump signals.

### SUMMARY

An example system for akinetic inductance travelling-wave parametric amplifier (KTWPA) device includes a metallic enclosure having a base including an inside top surface, sides, and an enclosure lid, the metallic enclosure forming a cavity, with a a substrate bonded to the inside top surface of the base, the substrate including a plurality of conductive pads, a silicon die including a superconducting transmission line, the silicon die coupled to the substrate, a plurality of conductive spacers, each having a top end and a bottom end, the bottom end of the plurality of conductive spacers coupled to the silicon die, a plurality of wire bonds coupled between the plurality of conductive pads and the silicon die; and a copper lid coupled to the top end of the plurality of conductive spacers. The copper lid is electrically and thermally coupled to the enclosure lid.

An example method for fabricating a kinetic inductance travelling-wave parametric amplifier (KTWPA) device, the method includes providing a metallic enclosure having a base including an inside top surface, sides, and an enclosure lid, the metallic enclosure forming a cavity, coupling a substrate to the inside top surface of the base, the substrate including a plurality of conductive pads, coupling a silicon die to the substrate, the silicon die including a superconducting transmission line, coupling a bottom end of each of a plurality of conductive spacers to the silicon die, coupling a plurality of wire bonds between the plurality of conductive pads and the silicon die, and coupling a copper lid to a top end of each of the plurality of conductive spacers. The copper lid is electrically and thermally coupled to the enclosure lid.

An example quantum microwave measurement circuit, includes a kinetic inductance travelling-wave parametric amplifier (KTWPA) device having an input port and an output port, the KTWPA device further including a metallic enclosure having a base including an inside top surface, sides, and an enclosure lid, the metallic enclosure forming a cavity, a substrate coupled to the inside top surface of the base, the substrate including a plurality of conductive pads, a silicon die including a superconducting transmission line, the silicon die coupled to the substrate, the superconducting transmission line further coupled to the input port and to the output port, a plurality of conductive spacers, each having a top end and a bottom end, the bottom end of the plurality of conductive spacers coupled to the silicon die, a plurality of wire bonds coupled between the plurality of conductive pads and the silicon die, and a copper lid coupled to the top end of the plurality of conductive spacers, where the copper lid is electrically and thermally coupled to the enclosure lid.

The quantum microwave measurement circuit further includes a first circulator coupled to a quantum circuit to receive a quantum measurement signal, a first microwave triplexer coupled to the first circulator to receive the quantum measurement signal and further coupled to the input port of the KTWPA device, the first microwave triplexer receiving a bias-in voltage and a microwave pump-in signal, a second microwave triplexer coupled to the output port of the KTWPA device to receive an amplified quantum measurement signal, the second microwave triplexer receiving a bias-out voltage and a microwave pump-out signal, a second circulator coupled to the second microwave triplexer to receive the amplified quantum measurement signal, and an analog-to-digital converter (ADC) coupled to the second circulator to receive the amplified quantum measurement signal and provide a quantum measurement value. The KTWPA device, the first circulator, the second circulator, the first microwave triplexer and the second microwave triplexer are cooled to less than 100 mK.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Furthermore, the claimed subject of this disclosure.

### BRIEF DESCRIPTION OF THE DRAWINGS

The drawing figures depict one or more implementations in accord with the present teachings, by way of example only, not by way of limitation. In the figures, like reference numerals refer to the same or similar elements. Furthermore, it should be understood that the drawings are not necessarily to scale.
FIG. 1 is a block diagram of a quantum microwave readout circuit implementing the KTWPA device as disclosed for low noise amplification and reliable handling of strong pump signals.
FIG. 2 illustrates a layout of a superconducting transmission line fabricated on a silicon die of the KTWPA device.
FIG. 3 is a cross-sectional view of the KTWPA device of an implementation with a silicon die mounted in a metallic enclosure with separate printed circuits with conductive pads.
FIG. 4 is a cross-sectional view of the KTWPA device of an implementation showing the silicon die mounted on a substrate with conductive pads that is further mounted in the metallic enclosure.
FIG. 5 is a cross-sectional view of the KTWPA device of an implementation with a set of stacked silicon dies mounted on the substrate.
FIG. 6 is a view of a superconducting transmission line fabricated on a silicon die of the KTWPA device similar to FIG. 2, further showing a layout of superconducting transmission lines with multiple silicon die constructed in a stack.
FIG. 7 is a side view of the metallic enclosure.
FIGs.8A-B depict a view of two steps of the manufacturing process for forming the KTWPA device of FIG. 4.
FIGs.9A-B depict a view of two steps of the manufacturing process for forming the KTWPA device of FIG. 4.
FIGs.10A-B depict a view of two steps of the manufacturing process for forming the KTWPA device of FIG. 4.
FIG. 11 shows a flow process of a method for forming the KTWPA device of FIG. 4.

### DETAILED DESCRIPTION

Kinetic inductance travelling-wave parametric amplifier (KTWPA) devices have become increasingly desirable to apply in microwave readout chains to measure large numbers of frequency-multiplexed microwave superconducting resonators at the quantum limit. KTWPA devices, compared with other quantum limited amplifiers such as devices that incorporate Josephson junctions, typically exhibit a combination of high dynamic range, wide frequency bandwidth, and low noise. Further proposed applications of microwave measurement chains include orders of magnitude more quantum devices that will need to be simultaneously read out, making the application of KTWPA devices even more prevalent.

To achieve the desired characteristics related to dynamic range, frequency bandwidth, and low noise, KTWPA devices require relatively high pump power to be applied at an input port to compensate for the relatively low non-linearity of the superconducting transmission line. The superconducting transmission line may be constructed using a buried trace geometry or a coplanar waveguide geometry. Further, the superconducting transmission line is constructed with a relatively long physical length, requiring that the superconducting transmission line be arranged in more compact patterns on the silicon die. The choice of materials to construct the superconducting transmission line in the KTWPA device is also important and Niobium Titanium Nitride (NbTiN) is often used given its unique properties for low dissipation and higher nonlinearity. It is further desirable that the KTWPA device accommodate multiple superconducting transmission lines in the same metallic enclosure to provide for a more compact device that simplifies the requirements for the cryogenic refrigerator that maintains the KTWPA device below the critical temperature.

Implementing the KTWPA device at the higher pump power applied at an input port to the superconducting transmission line which has been arranged in compact pattern on the silicon die raises several engineering and packaging problems. The higher pump power may create relative hot spots in various locations along superconducting transmission line, potentially creating a thermal runaway condition in which the hot spot temperature exceeds the critical temperature, causing the KTWPA device to lose superconductivity and ultimately fail to operate reliably. The compact arrangement of the superconducting transmission line requires a consistent ground plane along its entire length in order to maintain the desired gain, bandwidth, and noise characteristics.

It would be desirable to provide a KTWPA device with packaging and method of fabrication improvements that overcome the problems related to heat dissipation and ground plane that provide a compact and more reliable solution with improved amplification with a lower noise floor. The present invention describes improved heat dissipation methods to reliably handle higher pump power while maintaining a consistent ground plane along the length of the superconducting transmission line with improved KTWPA device packaging methods that include the use of conductive spacers, superconducting thin film traces, copper lids, and a metallic enclosure that is thermally and electrically conductive.

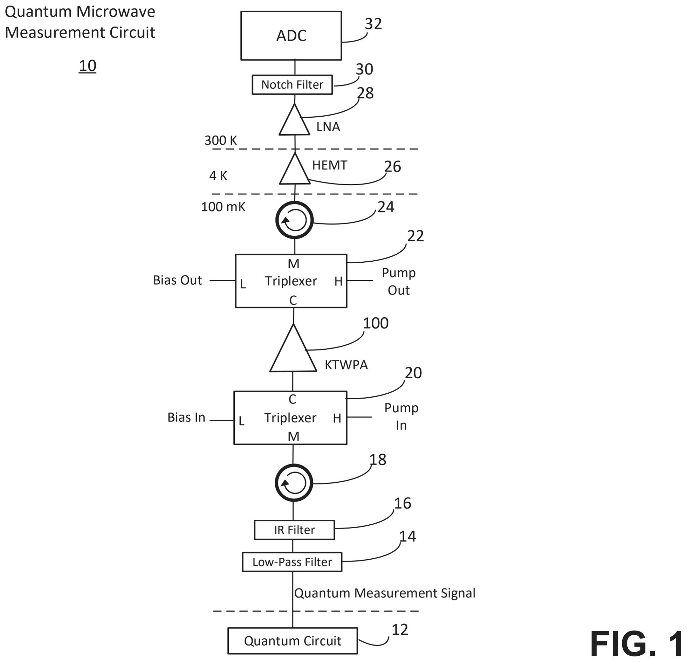

FIG. 1 is a block diagram of a quantum microwave readout circuit 10 implementing a KTWPA device 100 as disclosed in further detail below to provide low noise amplification and reliable handling of strong pump signals. A first microwave circulator 18 is coupled via a low-pass filter 14 and an infrared filter 16 to a quantum circuit 12 to receive a quantum measurement signal. The measurement is typically performed as part of a larger measurement system that provides microwave reflectometry measurements of a 1DTS topological qubit device for determining the fermion parity shared by a pair of MZMs. The low-pass filter 14 and infrared filter 16 each have characteristics selected to suppress stray radiation from impinging on the quantum circuit 12.

A first microwave triplexer 20 is coupled to the first circulator 18 to receive the quantum measurement signal, a bias-in voltage, and a microwave pump-in signal to produce a combined input signal that is provided to an input port of the KTWPA device 100. The KTWPA device 100 operates to amplify the quantum measurement signal at a desired very low noise level while reliably handling the pump in signal that is typically provided at a sufficient amplitude required by the KTWPA device 100 to function as intended.

A second microwave triplexer 22 is coupled to an output port of the KTWPA device 100 to receive a combined output signal. The second microwave triplexer 22 operates to separate the combined output signal into a microwave pump-out signal, a bias-out voltage, and an amplified quantum measurement signal. A second microwave circulator 24 is coupled to the second microwave triplexer 22 to receive the amplified quantum measurement signal. An analog-to-digital converter (ADC) 32 is coupled to second microwave triplexer 22 via a high electron mobility amplifier (HEMT) 26, a low noise amplifier (LNA) 26, and a notch filter 30 to receive a filtered quantum measurement signal to produce a quantum measurement value. The ADC 32 has selected sampling speed and resolution to match the requirements of the quantum microwave measurement circuit 10.

A first portion of the quantum microwave measurement circuit 10 from low pass filter 14, the IR filter 16, the circulator 18, the first microwave triplexer 20, the KTWPA device 100, the second microwave triplexer 22, and the second microwave circulator 24 are all cooled to less than 100 mK to maintain superconductivity. The HEMT 26 may be at a higher temperature, typically around 4K, and the LNA 28, the notch filter 30 and the ADC 32 may be at approximately 300K or typical room temperature. The KTWPA device 100 is applied in the quantum microwave measurement circuit 10 to achieve very low noise amplification of the quantum measurement signal while reliably handling a relatively large amplitude pump in signal, as described in more detail below.

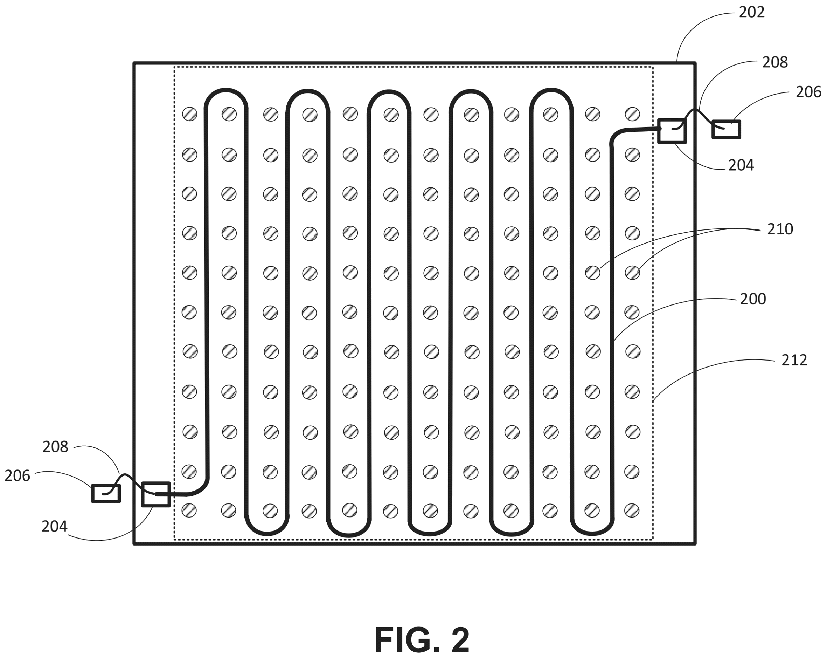

FIG. 2 depicts a superconducting transmission line 200 fabricated on a silicon die 202 of the KTWPA device 100. The superconducting transmission line 200 may be constructed using a buried trace geometry or a coplanar waveguide geometry, among other geometries that may be applied for fabricating transmission lines for operation at microwave frequencies, with the choice of geometry driven by engineering considerations that include relative size, fabrication ease, and desired performance. In order to provide a relatively long electrical length in a compact space, the superconducting transmission line 200 is arranged in a serpentine (or winding) pattern as shown. The superconducting transmission line 200 is a superconducting thin film that may be fabricated from various superconducting materials that include aluminum (Al), niobium (Nb), niobium nitride (NbN), titanium nitride (TiN), niobium titanium nitride (NbTiN), indium (In), and molybdenum rhenium (MoRe), all of which are particular types of superconducting thin films at qubit operating temperatures. Niobium titanium nitride (NbTiN) is preferably used in an implementation based on the particular properties of NbTiN as a transmission line structure with unique properties for low dissipation and higher nonlinearity. NbTiN has a critical temperature greater than 10 mK for superconductivity.

Conductive pads 204 are fabricated on each end of the superconducting transmission line 200 on the silicon die 202. The conductive pads 204 are further coupled to conductive pads 206 via wire bonds 208. The conductive pads 206 may be fabricated onto a printed circuit board or on a substrate to provide external connections to input ports and output ports of the KTWPA device 100. Other techniques for coupling the conductive pads 204 to the conductive pads 206 include tape-automated bonding (TAB) that use solder, conductive adhesive, or metal-to-metal thermionic bonding to a flexible printed circuit board. The selection of wire bonds 208, TAB, or a similar electrical interconnect technique, is driven by engineering considerations.

Conductive spacers 210 are arranged in a pattern in physically adjacent manner to the superconducting transmission line 200. Dimensions for routing the superconducting transmission line 200 and the separation of the conductive spacers 210 from the superconducting transmission line 200 are determined by engineering considerations for the desired electrical characteristics. The superconducting transmission line 200 throughout its entire length is routed in the serpentine pattern in order to provide the desired benefits for consistent thermal conductivity and a more consistent ground plane. The conductive spacers 210 may be implemented using gold stud bumps or equivalent alloys that operate to be both thermally and electrically conductive. The outline of a copper lid 212 is shown by the dashed line rectangle. Each of the conductive spacers 210 is bonded to the silicon die 202 at a bottom end and further bonded to the copper lid 212 at a top end. As a thermal conductor, each of the conductive spacers 210 operates to conduct thermal energy from the superconducting transmission line 200 to the copper lid 212 which acts as a heat sink to maintain the temperature of the superconducting transmission line 200 to maintain superconductivity along the entire length of the superconducting transmission line 200 and prevent hotspots that may result in thermal runaway and loss of superconductivity. Providing consistent thermal conductivity provides for the desired feature of the KTWPA device 100 to reliably handle higher pump signal power that may otherwise cause thermal runaway conditions. The conductive spacers 210 are also electrically conductive, allowing for a more consistent ground plane to be formed along the entire length of the superconducting transmission line 200, improving the desired characteristics as a superconducting transmission line with the desired properties for low noise amplification of weak microwave signals.

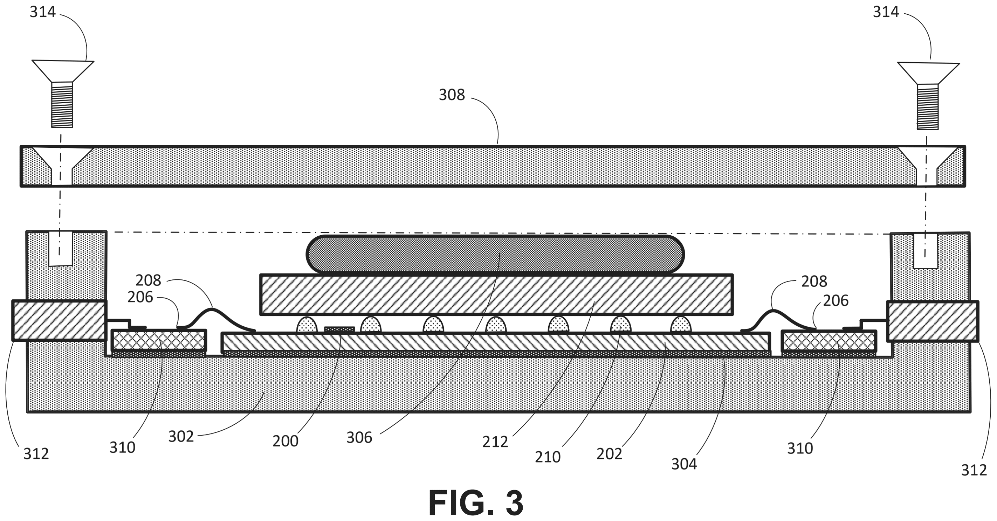

FIG. 3 is a cross-sectional view of the KTWPA device 100 of an implementation with the superconducting transmission line 200 fabricated on the silicon die 202. The silicon die 202 is bonded via a bonding compound 304 to an inside top surface of a base of a metallic enclosure 302 with separate printed circuits 310 having the conductive pads 206 fabricated thereon. Radio frequency (RF) connectors 312 are mounted in sides of the metallic enclosure 302 and are coupled to conductive pads 206 and further coupled to each end of the superconducting transmission line 200 to form the input port and the output port of the KTWPA device 10. The RF connector 312 may include SMA or similar wide bandwidth coaxial connectors.

The copper lid 212 is bonded to the upper end of each of the conductive spacers 210 to provide the advantages for reliably handling the higher pump signal power while delivering the low noise amplification of weak microwave signals as discussed above. The copper lid is thermally and electrically coupled to an enclosure lid 308 via a thermal interface material (TIM) 306. The enclosure lid 308 is mechanically attached to the metallic enclosure 302 via any of variety of fasteners that may include machine screws 314 arranged along the sides of the metallic enclosure 302. The enclosure lid 308 and the metallic enclosure 302 form a cavity in which the components of the KTWPA device 100 are placed.

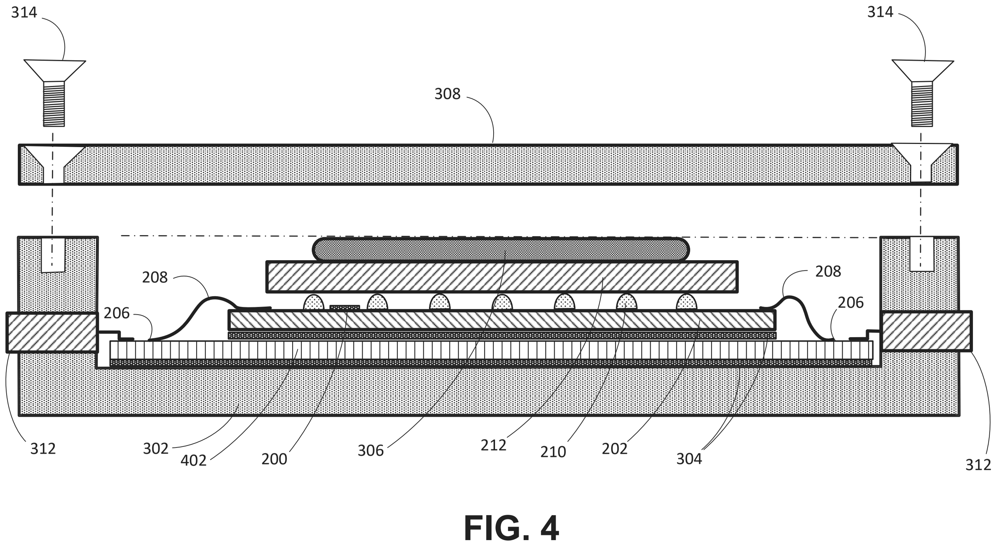

FIG. 4 is a cross-sectional view of the KTWPA device 100 of an implementation showing the silicon die 202 with the superconducting transmission line 200 fabricated on the silicon die 202 mounted on a substrate 402 with conductive pads 206 fabricated on the substrate 402. The substrate 402 is further bonded to the inner top surface of the metallic enclosure 302 via the bonding compound 304. The substrate 402 is constructed from aluminum nitride (AlN) that provides high thermal conductivity, high electrical insulation, and low dielectric constant.

The RF connectors 312 are mounted in the sides of the metallic enclosure 302 and are coupled to the conductive pads 206 and further coupled to each end of the superconducting transmission line 200 to form the input port and the output port of the KTWPA device 100. The RF connector 312 may include SMA or similar wide bandwidth coaxial connectors.

The copper lid 212 is bonded to the upper end of each of the conductive spacers 210 to provide the advantages for reliably handling the higher pump signal power while delivering the low noise amplification of weak microwave signals as discussed above. The copper lid is thermally and electrically coupled to an enclosure lid 308 via a thermal interface material (TIM) 306. The enclosure lid 308 is mechanically attached to the metallic enclosure 302 via machine screws 314 arranged along the sides of the metallic enclosure 302.

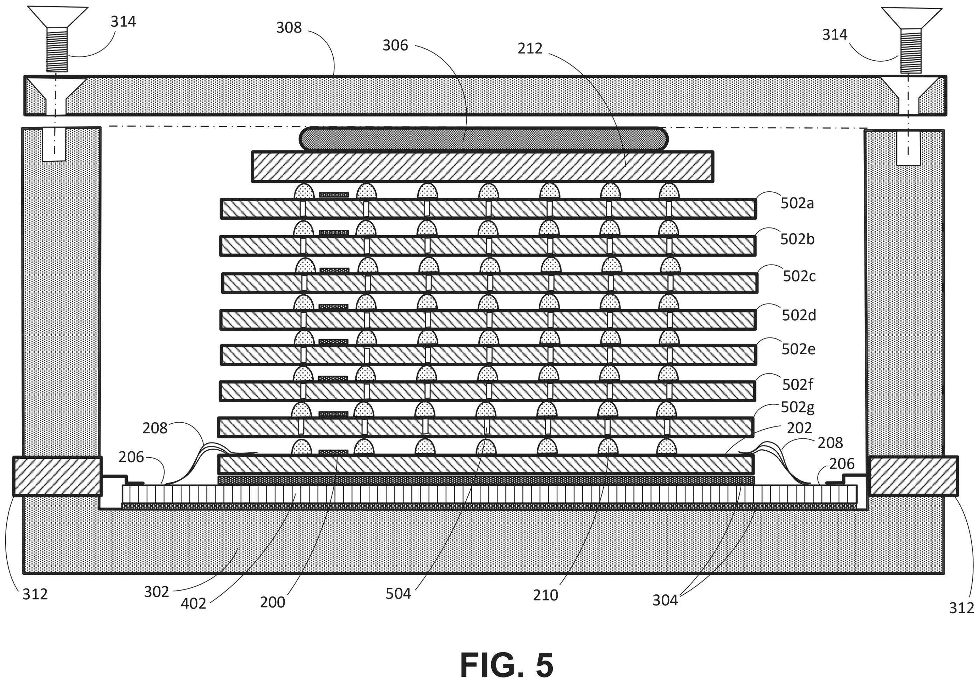

FIG. 5 is a is a cross-sectional view of the KTWPA device 100 of an implementation showing a set of stacked silicon dies 502a-g mounted on the silicon die 202. The silicon die 202 is further mounted on a substrate 402 with the conductive pads 206. The substrate 402 is further mounted to the inner top surface of the metallic enclosure 302 via the bonding compound 304. Each of the silicon die 502a-g and the silicon die 202 include the superconducting transmission line 200 and are coupled to an adjacent silicon die in the stack via the conductive spacers 210.

The RF connectors 312 are mounted in sides of the metallic enclosure 302 and are coupled to the conductive pads 206. A pair of RF connectors 312 are coupled to each end of the superconducting transmission line 200 for each of the silicon die 502a-g and the silicon die 20 to form respective input ports and the output ports of the KTWPA device 100. The RF connector 312 may include SMA or similar wide bandwidth coaxial connectors.

The copper lid 212 is bonded to the upper end of each of the conductive spacers 210. The silicon die 502a-g are constructed with through-silicon vias (TSVs) 504 that provide an electrically and thermally conductive path through the silicon die and are further bonded to the conductive spacers 210. The TSVs 504 disposed within each of the silicon die 502a-g and in combination with the conductive spacers 210 collectively provide the advantages for reliably handling the higher pump-in signal power while delivering the low noise amplification of weak microwave signals as discussed above. The copper lid is thermally and electrically coupled to an enclosure lid 308 via a thermal interface material (TIM) 306. The enclosure lid 308 is mechanically attached to the metallic enclosure 302 via machine screws 314 arranged along the sides of the metallic enclosure 302.

The set of stacked silicon dies 502a-g mounted on the silicon die 202 collectively allow a more compact and durable design for the KTWPA device 100 that now provides 8 parallel KTWPA transmission lines in one metallic enclosure 302. The advantage of this design is that a substantial increase in capacity for the KTWPA device 100 is achieved for only a modest gain in size, which is highly desirable for applications where sub-critical temperature real estate is limited. The set of stacked silicon dies 502a-g plus the silicon die 202 total 8 silicon die in the example illustration. Fewer or greater numbers of silicon die may be selected for the stack, driven by engineering limitations on how many silicon die can be fabricated in the stack as well as physical limitations such as enclosure dimensions, electrical performance including ground plane and thermal characteristics along with cross-talk between the superconducting transmission line 200 among the set of stacked silicon dies 502a-g.

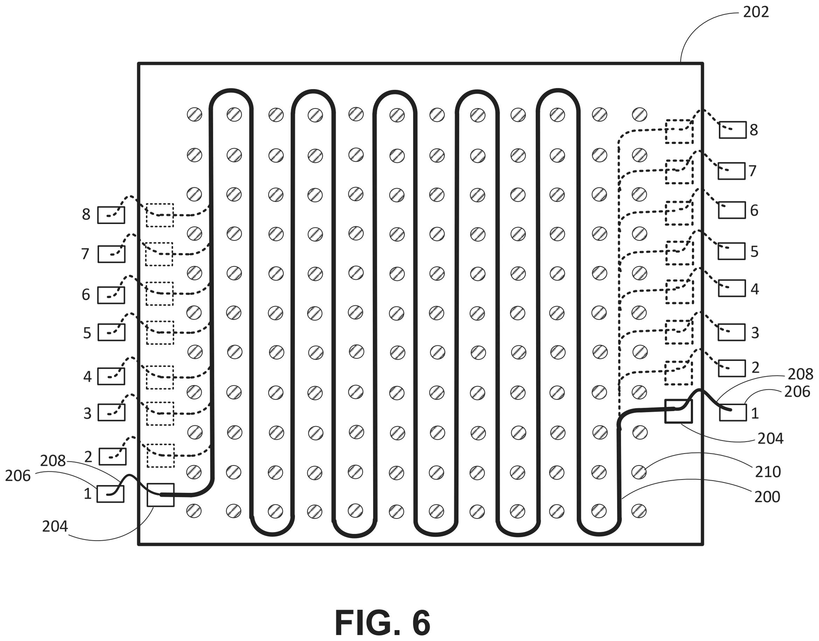

FIG. 6 is a view of a superconducting transmission line fabricated on a silicon die 202 of the KTWPA device 100 of FIG. 2, further showing a layout of additional superconducting transmission lines 200 fabricated on each of the set of stacked silicon die 502a-g constructed on top of and bonded to the silicon die 202 as shown in the cross-sectional view of FIG. 5. To accommodate the additional silicon die 502a-g, additional conductive pads 206 are fabricated on the substrate 402 corresponding to the conductive pads 204 on each of the silicon die 502a-g. The conductive pads on opposing sides of the silicon die 202 are numbered 1-8 to show the respective pairs 1-1, 2-2, and so on, through the set of stacked silicon die 502a-g that are each coupled to a respective pair of input ports and output ports. Additional wire bonds 208 connect each of the superconducting transmission line 200 via the conductive pads 204 to the respective pair of input ports and output ports of the KTWPA device 100. An alternative method of connecting the set of stacked silicon die 502a-g in lieu of or in combination with the additional wire bonds 208 is the use of the TSVs 504 with the conductive spacers 210 to couple the superconducting transmission lines 200 fabricated on each of the set of stacked silicon die 502a-g to the respective pair of input ports and output ports.

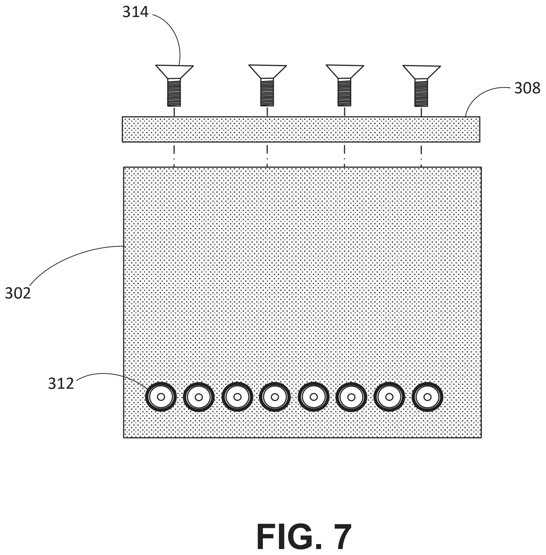

FIG. 7 shows a side view of the metallic enclosure 302 showing 8 RF connectors 312 mounted in the side of the metallic enclosure 302. The RF connectors 312 may be selectively deployed to provide the input ports and the output ports of the KTWPA device 100. A similar array of RF connectors 312 may be provided on another side, depending on the configuration of the KTWPA device 100. The enclosure lid 308 is attached to the metallic enclosure 302 using a desired number of machine screws 314 arranged along the sides of the metallic enclosure 302.

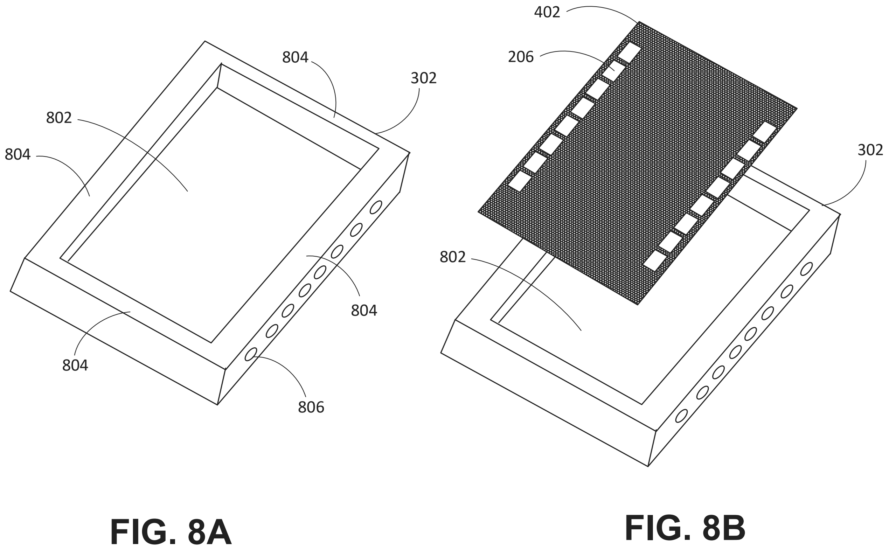

FIGs.8A-B depict a view of two steps of the manufacturing process for forming the KTWPA device 100 of FIG. 4. FIG. 8A shows the step of providing the metallic enclosure 302 which includes a base 802 having an inside top surface and sides 804. A set of apertures 806 may be provided along sides 804 to accommodate the RF connectors 312. The metallic enclosure 302 is constructed from a metal alloy that is electrically and thermally conductive. The metallic enclosure 302 may also provide magnetic shielding and include a ferrous metal as part of the metal alloy. FIG. 8B shows the step of bonding the substrate 402 having the set of conductive pads 206 to the inside top surface of the base 802.

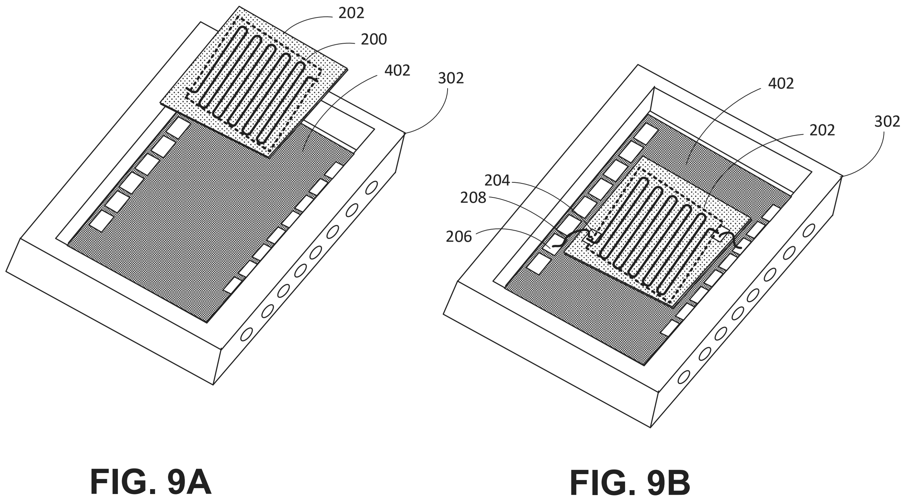

FIG.9A-B depicts a view of two steps of the manufacturing process for forming the KTWPA device 100 of FIG. 4. FIG. 9A shows the step of bonding the silicon die 202 to the substrate 402. The substrate 402 is constructed from aluminum nitride (AlN) that provides high thermal conductivity, high electrical insulation, and low dielectric constant. FIG. 9B shows the step of adding the wire bonds 208 between the conductive pad 206 on the substrate 402 and the conductive pad 204 on the silicon die 202. The conductive spacers 210 (not shown) would preferably have already been installed on the silicon die 202 during the fabrication process prior to installation in the metallic enclosure 302.

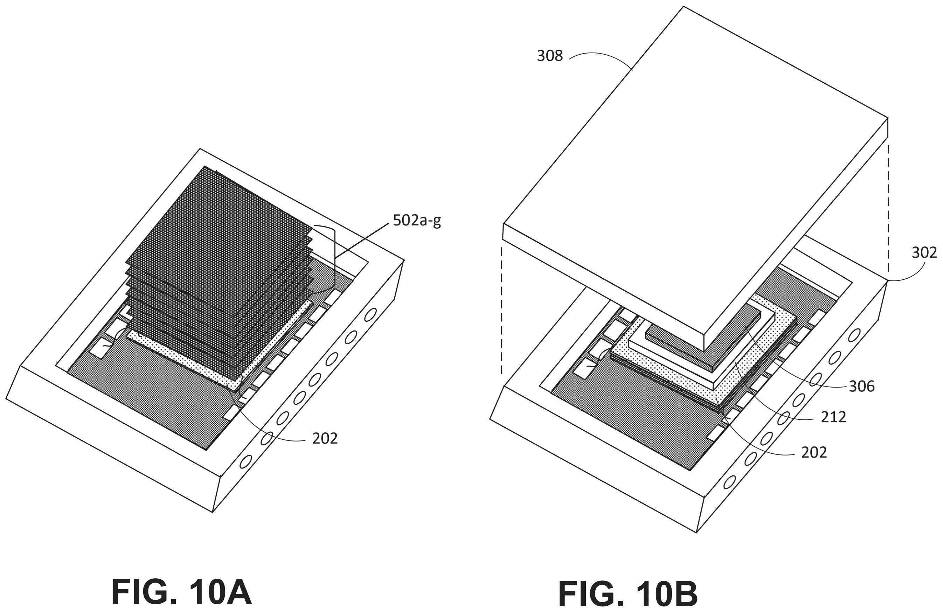

FIG.10A-B depicts a view of two steps of the manufacturing process for forming the KTWPA device 100 of FIG. 4. FIG. 10A shows an optional step of bonding the set of stacked silicon dies 502a-g to the silicon die 202. The set of stacked silicon dies 502a-g are preferably fabricated as single unit prior to bonding to the silicon die 202 but could also be bonded in singular fashion, as dictated by fabrication constraints. Additional wire bonds 208 would then be added for each of the stacked silicon dies 502a-g in a similar manner as the silicon die 202. FIG. 10B shows the step of bonding the copper lid 212 to the upper end of each of the conductive spacers 210 which are further bonded to the silicon die 202. The thermal interface material (TIM) 306 is mounted on top of the copper lid 212 to provide electrical and thermal conductivity between the copper lid 212 and the enclosure lid 308. The enclosure lid is mounted to the enclosure 302 to complete the manufacturing process.

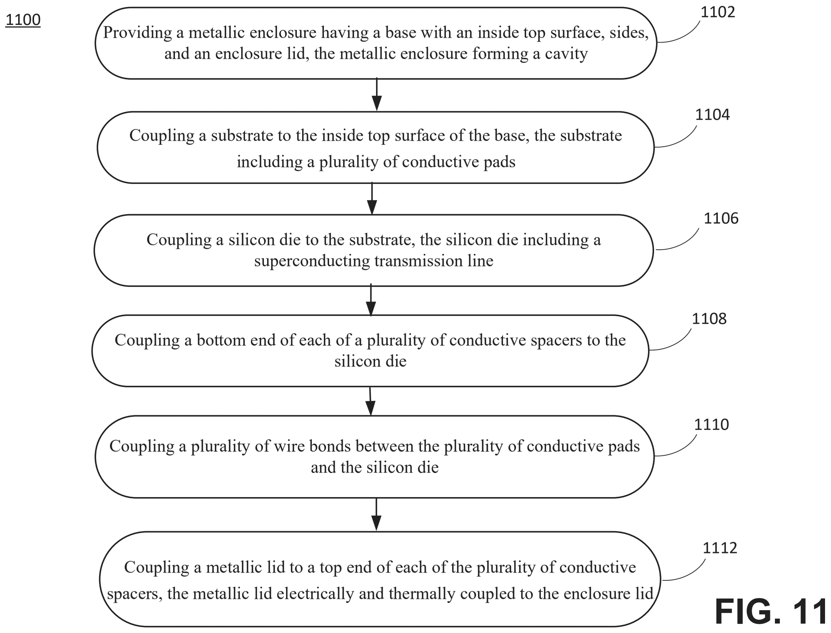

FIG. 11 shows a flow process 1100 of a method for forming the KTWPA device 100. The flow process 1100 includes step 1102 for providing the metallic enclosure 302 which includes the base 802 having an inside top surface, the sides 804, and the enclosure lid 308. The metallic enclosure 302 and the enclosure lid 308 are constructed from a metal alloy that is electrically and thermally conductive. The metallic enclosure 302 and the enclosure lid 308 may also provide magnetic shielding and include a ferrous metal as part of the metal alloy.

The flow process 1100 further includes step 1104 for bonding a substrate 10 to the inside top surface of the base 802, the substrate 402 including a plurality of conductive pads 206. The substrate 402 is constructed from aluminum nitride (AlN) that provides high thermal conductivity, high electrical insulation, and low dielectric constant. The substrate 402 is further bonded to the inner top surface of the metallic enclosure 302 via the bonding compound 304. The conductive pads 206 may be fabricated on the substrate 402 to provide external connections to input ports and output ports of the KTWPA device 100.

The flow process 1100 further includes step 1106 for bonding the silicon die 202 to the substrate 402. The silicon die 202 includes the superconducting transmission line 200. The superconducting transmission line 200 may be constructed using a buried trace geometry or a coplanar waveguide geometry, among other geometries that may be applied for fabricating transmission lines for operation at microwave frequencies, with the choice of geometry driven by engineering considerations that include relative size, fabrication ease, and desired performance The silicon die 202 is bonded via the bonding compound 304 (not shown) to the substrate 402.

The flow process 1100 further includes step 1108 for bonding a bottom end of each of a plurality of conductive spacers 210 to the silicon die 202. The conductive spacers 210 are bonded to the silicon die 202 and arranged in close proximity to the superconducting transmission line 200 as illustrated in FIG. 2. The process of bonding the conductive spacers 210 to the silicon die 202 can take place during the fabrication process of the silicon die 202 or could be done after the silicon die 202 is bonded to the substrate 402.

The flow process 1100 further includes step 1110 for attaching a plurality of wire bonds 208 between the plurality of conductive pads 206 on the substrate 402 and the conductive pads 206 on the silicon die 202. In the case shown in FIG 10A in which the set of stacked silicon dies 502a-g is bonded to the silicon die 202, additional wire bonds 208 would then be added for each of the stacked silicon dies 502a-g in a similar manner as the silicon die 202. The manner of adding wire bonds 208 in the confined space of the metallic enclosure 302 is a matter of engineering choice.

The flow process 1100 further includes step 1112 for bonding the copper lid 212 to a top end of each of the plurality of conductive spacers 210. The copper lid 212 is electrically and thermally coupled to the enclosure lid 308. The thermal interface material (TIM) 306 is provided between the copper lid 212 and the enclosure lid 308 to provide additional thermal and electrical conductivity. The enclosure lid 308 is attached to the metallic enclosure 302 using any of a variety of fasteners that may include the machine screws 314.

While various embodiments have been described, the description is intended to be exemplary, rather than limiting, and it is understood that many more embodiments and implementations are possible that are within the scope of the embodiments. Although many possible combinations of features are shown in the accompanying figures and discussed in this detailed description, many other combinations of the disclosed features are possible. Any feature of any embodiment may be used in combination with or substituted for any other feature or element in any other embodiment unless specifically restricted. Therefore, it will be understood that any of the features shown and/or discussed in the present disclosure may be implemented together in any suitable combination. Accordingly, the embodiments are not to be restricted except in light of the attached claims and their equivalents. Also, various modifications and changes may be made within the scope of the attached claims.

While the foregoing has described what are considered to be the best mode and/or other examples, it is understood that various modifications may be made therein and that the subject matter disclosed herein may be implemented in various forms and examples, and that the teachings may be applied in numerous applications, only some of which have been described herein. It is intended by the following claims to claim any and all applications, modifications and variations that fall within the true scope of the present teachings.

Unless otherwise stated, all measurements, values, ratings, positions, magnitudes, sizes, and other specifications that are set forth in this specification, including in the claims that follow, are approximate, not exact. They are intended to have a reasonable range that is consistent with the functions to which they relate and with what is customary in the art to which they pertain.

The scope of protection is limited solely by the claims that now follow. That scope is intended and should be interpreted to be as broad as is consistent with the ordinary meaning of the language that is used in the claims when interpreted in light of this specification and the prosecution history that follows and to encompass all structural and functional equivalents. Notwithstanding, none of the claims are intended to embrace subject matter that fails to satisfy the requirement of Sections 101, 102, or 103 of the Patent Act, nor should they be interpreted in such a way. Any unintended embracement of such subject matter is hereby disclaimed.

Except as stated immediately above, nothing that has been stated or illustrated is intended or should be interpreted to cause a dedication of any component, step, feature, object, benefit, advantage, or equivalent to the public, regardless of whether it is or is not recited in the claims.

It will be understood that the terms and expressions used herein have the ordinary meaning as is accorded to such terms and expressions with respect to their corresponding respective areas of inquiry and study except where specific meanings have otherwise been set forth herein. Relational terms such as first and second and the like may be used solely to distinguish one entity or action from another without necessarily requiring or implying any actual such relationship or order between such entities or actions. The terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus. An element proceeded by "a" or "an" does not, without further constraints, preclude the existence of additional identical elements in the process, method, article, or apparatus that comprises the element. Furthermore, subsequent limitations referring back to "said element" or "the element" performing certain functions signifies that "said element" or "the element" alone or in combination with additional identical elements in the process, method, article or apparatus are capable of performing all of the recited functions.

The disclosure provides many different embodiments, or examples, for implementing different features of the provided subject matter. Specific examples of components and arrangements are described to simplify the present disclosure. These are merely examples and are not intended to be limiting. For example, the formation of a first feature over or on a second feature in the description that follows may include embodiments in which the first and second features are formed in direct contact, and may also include embodiments in which additional features may be formed between the first and second features, such that the first and second features may not be in direct contact. Further, spatially relative terms, such as "beneath," "below," "lower," "above," "upper," "back," "front," "top," "bottom," and the like, are used herein for ease of description to describe one element or feature's relationship to another element(s) or feature(s) as illustrated in the figures. The spatially relative terms are intended to encompass different orientations of the device in use or operation in addition to the orientation depicted in the figures.

The Abstract of the Disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various examples for the purpose of streamlining the disclosure. This method of disclosure is not to be interpreted as reflecting an intention that the claims require more features than are expressly recited in each claim. Rather, as the following claims reflect, inventive subject matter lies in less than all features of a single disclosed example. Thus, the following claims are hereby incorporated into the Detailed Description, with each claim standing on its own as a separately claimed subject matter.

## Claims

1. A kinetic inductance travelling-wave parametric amplifier, KTWPA, device, comprising:
a metallic enclosure having a base including an inside top surface, sides, and an enclosure lid, the metallic enclosure forming a cavity;
a substrate bonded to the inside top surface of the base, the substrate including a plurality of conductive pads;
a silicon die including a superconducting transmission line, the silicon die coupled to the substrate;
a plurality of conductive spacers, each having a top end and a bottom end, the bottom end of the plurality of conductive spacers coupled to the silicon die;
a plurality of wire bonds coupled between the plurality of conductive pads and the silicon die; and
a copper lid coupled to the top end of the plurality of conductive spacers, wherein the copper lid is electrically and thermally coupled to the enclosure lid.

2. The KTWPA device of claim 1, further comprising:
a) a thermal interface material coupled between the copper lid and the enclosure lid; and/or
b) comprising a plurality of radio frequency, RF, connectors disposed in the sides of the metallic enclosure and coupled to the plurality of conductive pads

3. The KTWPA device of claim 1 or claim 2, wherein the superconducting transmission line is arranged in a serpentine pattern that is routed among the plurality of conductive spacers on the silicon die.

4. The KTWPA device of any preceding claim, wherein the superconducting transmission line is a superconducting thin film.
optionally wherein the superconducting thin film comprises Niobium Titanium Nitride, NbTiN.

5. The KTWPA device of any preceding claim, wherein the enclosure lid is fastened to the metallic enclosure using a plurality of machine screws on the sides.

6. The KTWPA device of any preceding claim, further comprising a plurality of the silicon die constructed in a stack, each of the plurality of the silicon die coupled to an adjacent silicon die in the stack via the plurality of the conductive spacers, the plurality of the silicon die further including through-silicon vias, TSVs, that electrically couple each of the adjacent silicon die through the conductive spacers.

7. The KTWPA device of any preceding claim, wherein:
a) the substrate further comprises aluminum nitride, AlN; and/or
b) the plurality of conductive spacers comprises gold stud bumps.

8. A quantum microwave measurement circuit, comprising:
a KTWPA device as defined in any preceding claim, wherein the superconducting transmission line is coupled to an input port and to an output port;
a first circulator coupled to a quantum circuit to receive a quantum measurement signal;
a first microwave triplexer coupled to the first circulator to receive the quantum measurement signal and further coupled to the input port of the KTWPA device, the first microwave triplexer receiving a bias-in voltage and a microwave pump-in signal;
a second microwave triplexer coupled to the output port of the KTWPA device to receive an amplified quantum measurement signal, the second microwave triplexer receiving a bias-out voltage and a microwave pump-out signal;
a second circulator coupled to the second microwave triplexer to receive the amplified quantum measurement signal; and
an analog-to-digital converter, ADC, coupled to the second circulator to receive the amplified quantum measurement signal and provide a quantum measurement value, wherein the KTWPA device, the first circulator, the second circulator, the first microwave triplexer and the second microwave triplexer are cooled to less than 100 mK.

9. A method of fabricating a kinetic inductance travelling-wave parametric amplifier, KTWPA, device, the method comprising;
providing a metallic enclosure having a base including an inside top surface, sides, and an enclosure lid, the metallic enclosure forming a cavity;
coupling a substrate to the inside top surface of the base, the substrate including a plurality of conductive pads;
coupling a silicon die to the substrate, the silicon die including a superconducting transmission line;
coupling a bottom end of each of a plurality of conductive spacers to the silicon die;
coupling a plurality of wire bonds between the plurality of conductive pads and the silicon die; and
coupling a copper lid to a top end of each of the plurality of conductive spacers, wherein the copper lid is electrically and thermally coupled to the enclosure lid.

10. The method of fabricating a KTWPA device of claim 9, further comprising:
a) coupling a thermal interface material between the copper lid and the enclosure lid; and/or
b) coupling a plurality of radio frequency, RF, connectors to the plurality of conductive pads to form an input port and an output port.

11. The method of fabricating a KTWPA device of claim 9 or claim 10, further comprising arranging the superconducting transmission line in a serpentine pattern that is routed among the plurality of conductive spacers on the silicon die.

12. The method of fabricating a KTWPA device of any of claims 9 to 11, wherein the superconducting transmission line is a superconducting thin film;
optionally wherein the superconducting thin film comprises Niobium Titanium Nitride, NbTiN.

13. The method of fabricating a KTWPA device of any of claims 9 to 12, further comprising fastening the enclosure lid to the metallic enclosure on each of the sides using a plurality of machine screws.

14. The method of fabricating a KTWPA device of any of claims 9 to 13, wherein the substrate comprises aluminum nitride, AlN.

15. The method of fabricating a KTWPA device of any of claims 9 to 14, further comprising:
constructing a plurality of silicon die in a stack; and
coupling the plurality of the silicon die to an adjacent silicon die in the stack via the plurality of conductive spacers, the plurality of silicon die further including through-silicon vias (TSVs) disposed in each of the plurality of the silicon die to electrically couple the adjacent silicon die through the conductive spacers.
